# EUROPEAN PATENT SPECIFICATION

(11) **EP 2 887 409 B1**
(45) Date of publication and mention of the grant of the patent: **15.06.2016**
(21) Application number: 13197801.7
(22) Date of filing: 17.12.2013
(51) Int. Cl.: H01L 35/30

(54) **Micromachined energy harvester with a thermoelectric generator and method for manufacturing the same**
Mikrogefertigter Energiesammler mit einem thermoelektrischen Generator und Herstellungsverfahren dafür
Moissonneuse d'énergie micro-usinée avec un générateur thermoélectrique et son procédé de fabrication

(43) Date of publication of application: 24.06.2015
(73) Proprietor: Airbus Defence and Space GmbH, 85521 Ottobrunn (DE)
(72) Inventor: Becker, Thomas, 27711 Osterholz-Scharmbeck (DE); Elefsiniotis, Alexandros, 81375 München (DE); Schmid, Ulrich, 1140 Wien (AT)
(74) Representative: Kastel, Stefan

(56) References cited:
- EP-A2- 1 443 568
- EP-A2- 2 475 019
- WO-A2-2009/156382
- DE-A1-102008 031 266
- DE-A1-102009 038 925
- US-A1- 2006 090 885
- US-B1- 6 313 393

## Description

The invention relates to an energy harvester comprising at least one thermoelectric generator. Still further, the invention relates to a method for manufacturing of such an energy harvester.

Thermoelectric generators - also referred to as TEGs in the following - based, for example, on the Seebeck effect are well-known and commercially available. Examples for thermoelectric generators according to the state of art are described in DE 10 2008 031 266 A1.

Typically, the "quasi" static temperature difference between two areas is being exploited for energy harvesting purposes.

Energy harvesting - also known as power harvesting or energy scavenging - is the process by which energy is derived from external sources such as solar power, thermal energy, wind energy, salinity gradients, and kinetic energy, captured and stored for small, wireless autonomous devices, like those used in variable electronics and wireless sensor networks. Known energy harvesters provide a very small amount of power for low-energy electronics. While the input fuel to some large-scale generation costs money, the energy source for energy harvesters is present as ambient background and is free. For example, temperature gradients exist from the use of a combustion engine. For further details to energy harvesting and thermoelectric generators used in energy harvesting, it is especially referred to Dominik Samson, Energy Harvesting in Aircraft with Special Focus of Thermoelectrics, Dissertation, TU Vienna, 2011.

In this study, an approach is described how to generate an artificial temperature difference by the sensible and latent heat of a phase change of a material (phase change material, also referred to as PCM) and called "dynamic TEG harvester". Further details for such dynamic TEG harvester are also derivable from DE 10 2009 038 925 A1.

Such thermoelectric generator as known from DE 10 2009 038 925 A1 has been proven as very effective and very well suited for a use on or in aircrafts. However, still, there are possibilities to improve the known thermoelectric generator, especially in view to have a smaller and more compact design so that it can be integrated easier onto the inner surface of the aircraft fuselage or the like. Further, the manufacture and the mounting of the present thermoelectric harvester comprising a TEG and PCM container as key components is quite complicated as the latter component is precision-machined and attached to the TEG by spring-forces.

US 6 313 393 discloses a heat transfer and electric-power generating component containing a thermoelectric device. The component utilizes microstructural architecture for enhanced heat transfer. The component includes a heat source and a microstructural heat sink. The component comprises several chambers that are in fluid connection via microchannels wherein a refrigerant solution such as LiBr/H2O or NH3/H2O that is passed between the chambers. The component is used in cooling of protective clothing.

EP 1 443 568 A2 discloses a micro-fabricated device with thermoelectric device and a method of making the same. The thermoelectric device is supplied with current in order to effect a cooling or heating of a microprocessor.

The invention aims to solve the problem to provide a very compact, effective energy harvester that can be manufactured in a cost-effective way.

This problem is solved by an energy harvester with the features of claim 1 and by a method for manufacturing an energy harvester according to the further independent claim.

Advantageous embodiments form the subject matter of the sub-claims.

According to one aspect the invention provides an energy harvester, comprising at least one thermoelectric generator and a housing formed at least partly by MEMS (micro electromechanical systems) manufacturing from a substrate, wherein a heat storage medium is included in a chamber in the housing.

Preferably, the at least one thermoelectric generator is produced on the substrate or is fixed to the substrate.

Preferably, there is provided an energy harvester comprising at least one thermoelectric generator, wherein a housing is formed at least partly by making most beneficially use of MEMS manufacturing techniques from a substrate, wherein a heat storage medium is included in a chamber in the housing, and wherein the at least one thermoelectric generator element is produced on or fixed to the substrate or is at least in contact with the substrate.

According to the invention, the heat storage medium is a phase change material encapsulated within the chamber

Preferably, the heat storage medium is or includes a fluid.

Preferably, the heat storage medium is or includes a material having a solid, liquid or gaseous state at least in a part of the operation temperature range of the thermoelectric generator.

Preferably, the substrate is made from a semiconductor material, such as silicon.

Preferably, the substrate forms a first wall of the chamber, and a cover element forms a second wall of the chamber.

Preferably, the first wall has protrusions and recesses for enlarging the contact area contacting the phase change material.

Preferably, the cover element includes an encapsulation made from a material that is transmissive for visible and/or infrared light.

Preferably, the first wall has a light absorbing surface, especially a black surface. For example, the surface material of the first wall has an absorption factor or absorptance of at least 0.5, more preferable at least 0.9 or more.

According to the invention, the substrate has a micromachined cavity as part of the chamber.

Preferably, said at least one thermoelectric generator is provided by a plurality of micromachined thermoelectric generators produced on or fixed to the substrate.

Preferably, the at least one thermoelectric generator is arranged on a side of the substrate facing away from the chamber.

Preferably, the substrate comprises a wafer wherein at least one cavity is formed in a first side of the wafer and an arrangement of thermoelectric generator elements is located on a second side of the wafer.

Preferably, the at least one cavity covers at least 50%, more preferably, at least 75% and most preferable more than 90% of the surface area of the first side of the wafer.

According to a further aspect, the invention provides a method for manufacturing an energy harvester including at least one thermoelectric generator, wherein the method comprises the steps:
a) micromachining at least a part of at least one chamber in a substrate,
b) providing a heat storage medium to fill the chamber, and
c) arranging at least one thermoelectric generator on or in contact with the substrate.

The use of reference signs such as a), b), and c) is just made for an easy reference and shall not mean a specific ordering. For, example step c) may be conducted before step b). If the option "in contact with the substrate" is chosen, the steps b) and c) may be changed, so that first a filling procedure is performed, followed by a assembly procedure.

Preferably, step a) comprises
a1) providing a substrate made from a semiconductor material, preferably silicon.

Preferably, step a) comprises
a2) providing a wafer as substrate.

Preferably, step a2) comprises
a2.1)forming at least one cavity, and preferably exactly one cavity, for receiving heat storage medium such as phase change material at a first side of the wafer, and
wherein step c) comprises providing an arrangement of thermoelectric generator elements at a second side of the wafer.

Preferably, step a) comprises
a3) etching at least one cavity into the substrate to form a first side of the chamber.

Preferably, step a) comprises
a4) forming a side wall of the chamber on the substrate with protrusions and recesses for enlarging a contact area to be in contact with the heat storage medium, e.g. phase change material.

Preferably, step a) comprises
a5) treating a surface of a side wall of the chamber to enlarge a heat radiation absorption capability.

According to the invention, step a) comprises: micromachining a cavity into the substrate and the method comprises the further step:
d) closing the cavity to form the chamber.

Preferably, step d) comprises
d1) attaching a cover element or an encapsulation on the substrate.

Preferably, step d) comprises
d2) providing a cover element or an encapsulation made from material transparent for visible and/or infrared light.

According to the invention, step b) comprises:
b1) supplying a phase change material to fill the chamber and/or
b2) filling the chamber with a phase change material.

Preferably, step b) comprises:
b3) providing a fluid as heat storage medium. The fluid is preferably a liquid in at least a part of the typical operation temperature range of the thermoelectric generator.

Preferably, step c) comprises
c1) providing an arrangement of a plurality of micromachined thermoelectric generator elements.

Preferably, step c) comprises
c2) arranging the at least on thermoelectric generator element on a side of the substrate facing away from the chamber.

A preferred aspect of the invention refers to an ultra-thin realisation of a thermoelectric generator device with heat storage medium by using micro- and/or nanomachining. With these MEMS/NEMS-based technologies, a flat design of a PCM housing is possible. For example, a housing for heat storage medium can be made using a wafer. With this embodiment, one could provide a chamber for heat storage medium in the form of a phase change material which extends over nearly the whole surface of the wafer.

The maximum lateral dimensions are given by the size of the wafer used in the manufacture. Preferably, at least a 6" wafer or a wafer with a larger size is used to form the substrate. With at least a 6" wafer, cavities for the heat storage medium such as phase change material can be achieved with the size in the order of some tens of millimetres.

By using a MEMS based approach, the thermoelectric generator elements could be integrated. This is especially advantageous in such cases, where the thermoelectric generators are also produced in a similar way. Examples for thermoelectric generators produced by using MEMS technologies are given in WO 2009/156382 A2 and WO 2011/039240 A2. For further details with regard to the method to produce such thermoelectric generators and to the features of such thermoelectric generators produced therewith, it is especially referred to these documents which are incorporated herein by reference.

One main advantage according to the invention or according to the preferred embodiments thereof is that a very flat design can be achieved which allows the integration in a large amount of different parts of an aircraft. Further, well-established bonding techniques can be applied such as soldering or eutectic bonding, to decrease the temperature drop across this interface to a minimum. Such bonding techniques can be applied easily when a PCM container as well as the TEG are fabricated applying the same technology platform. Due to the flat and compact design, even an integration in a rotor blade or in the aircraft fuselage or in the aircraft skin is possible. For further details to integrate an electronic element into a rotor blade, it is especially referred to DE 10 2008 053 072 A1.

Another advantage is the cheap MEMS production technique in case of mass production.

One possible use of such an energy harvester, as described herein, is a surveilling network for an aircraft. Aircraft maintenance can be time consuming and expensive. It is much simpler if the airplane itself reports, where maintenance is required. The best solution is an approach for the sensor network, which even provides its own power supply and is therefore independent of electrical wiring. For each individual sensor, electricity is produced by a thermoelectric generator with a small water tank, storing thermal energy. The electricity is simply generated from the temperature difference between the icy cold air in high altitudes and the water-based heat storing unit (and vice versa). This novel approach for providing locally the energy for the operation of the sensor network could not only facilitate aircraft maintenance, but also increase comfort for travellers.

Preferred embodiments of the invention provide especially one, several or all of the following advantages:
- Standard MEMS technologies could be used for production and integration.
- Thermoelectric generators made with the same technology can be integrated in an easy manner, offering low thermal resistance between the thermoelectric generator element and the heat storage medium container.
- A smooth surface at the container bottom is available.
- Ultra-thin devices are possible.
- An optical inspection of the device using light is possible.
- Preferred embodiments allow designs for using additional heating of the heat storage medium, such as PCM by radiation, such as by visible light or by IR.
- Preferred embodiments allow providing a silicon black layer in order to increase the absorption. Different etching technologies allow specific designs of the heat sink inside the container.

Preferred embodiments of the invention are further explained in more detail with reference to the enclosed drawings:
- Fig. 1: is a schematic sectional view through a first embodiment of an energy harvester; and
- Fig. 2: is a schematic view similar to Fig. 1 showing a further embodiment of an energy harvester.

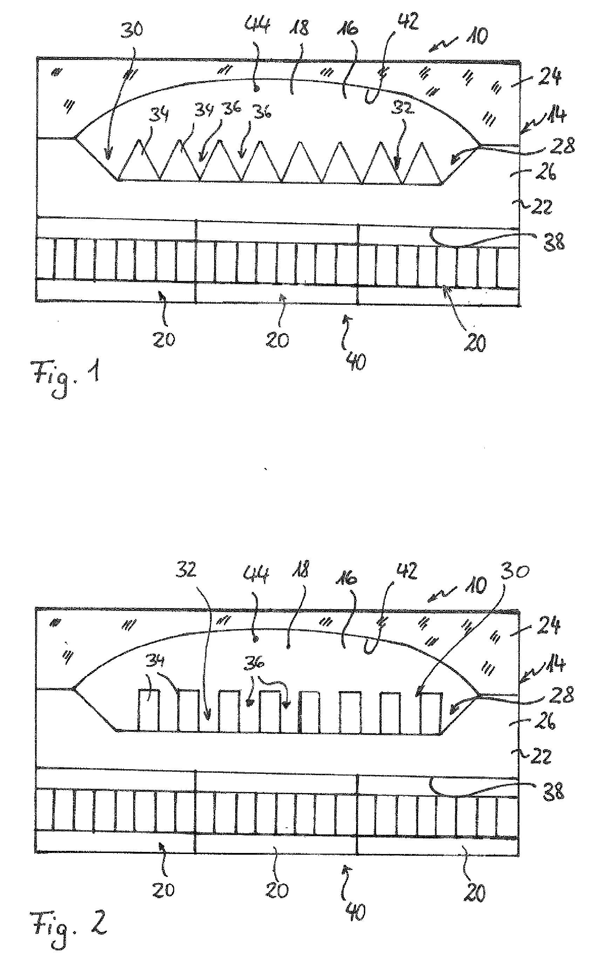

Referring first to Fig. 1, there is shown an energy harvester 10. The energy harvester 10 includes at least one thermoelectric generator 20 for converting thermal energy into electrical energy. The energy harvester 10 comprises a housing 14 with a chamber 16 that encloses a heat storage medium 18.

In the embodiments shown, the energy harvester 10 comprises a plurality of thermoelectric generators 20.

The housing 14 is manufactured using a substrate 22 and a cover element 24.

The substrate 22 is preferably made using a wafer 26. Especially, at least a 6" wafer or a wafer 26 having larger size is used. Especially, the wafer 26 is a semiconductor wafer 26, such as a silicon wafer.

For manufacturing the energy harvester 10, this wafer 26 is formed using MEMS technologies such as deposition of layers, photolithography, and etching steps in such way that a cavity 28 is formed on a first side 30 of the wafer 26. This cavity 28 forms a first side 32 of the chamber 16. This first side 32 is provided with protrusions 34 and recesses 36 that are made during the MEMS manufacturing, for enlarging the surface area providing a heat exchange between the heat storage medium 18 and the substrate 22.

On the second side 38 of the wafer 26 which side 38 faces away from the cavity 28, an arrangement of the thermoelectric generators 20 is produced on the substrate 22 or fixed to the substrate 22, for example by bonding.

In a preferred embodiment, the arrangement 40 of thermoelectric generators 20 is manufactured as described in WO 2011/039240 A2 and/or WO 2009/156382 A2. Such thermoelectric generators 20 are also available from the company Micropelt GmbH, D-79110 Freiburg, Germany.

The cover element 24 forms a second side 42 of the chamber 16. Preferably, the cover element is made from a material with high transmission for radiation to heat the heat storage medium 18 inside the chamber 16. Especially, the material of the cover element 24 has a high transmission for light or infrared light.

The first side 32 of the chamber has a high absorption for such radiation. Especially, a black surface is provided on this first side 32.

The cover element 24 is especially made from glass, e.g. Pyrex-type glass. The cover element 24 is patterned to increase the cavity volume using e.g. hydrofluorid acid.

The heat storage medium present within the chamber 16 is a phase change material 44. Phase change materials that are suitable for this purpose are especially described in DE 10 2009 038 925 A1, in DE 10 2008 031 266 A1 and in Dominik Samson, Energy Harvesting in Aircraft with Special Focus on Thermoelectrics, Dissertation, TU Vienna, 2011.

Hence, Fig. 1 shows a first embodiment of a MEMS based TEG PCM energy harvester 10 with micromachined thermoelectric generators 20, an anisotropic etched silicon body - substrate 22 - mounted face down on the thermoelectric generator elements 20 and an encapsulation - cover element 24 -, especially using Pyrex-type glass.

Fig. 2 shows a second embodiment which is quite similar to the first embodiment, however, the first side 32 of the chamber which is formed by the cavity 28 in the wafer 26 is etched with another technology. Hence, the protrusions 34 and recesses 36 are formed in a different way.

### List of reference signs:

- 10: energy harvester
- 14: housing
- 16: chamber
- 18: heat storage medium
- 20: thermoelectric generator
- 22: substrate
- 24: cover element
- 26: wafer
- 28: cavity
- 30: first side of the wafer
- 32: first side of the chamber
- 34: protrusion
- 36: recess
- 38: second side of the wafer
- 40: arrangement
- 42: second side of the chamber
- 44: phase change material

## Claims

1. Energy harvester (10), comprising at least one thermoelectric generator (20), and a micromachined housing (14) formed at least partly by MEMS manufacturing from a substrate (22), wherein a heat storage medium (18) is included in a chamber (16) in the housing (14) **characterized in that** the heat storage medium (18) is a phase change material (44), **in that** the substrate (22) has a micromachined cavity (28) wherein the cavity (28) closed by an encapsulation forms the chamber (16), and **in that** the chamber (16) encloses the heat storage medium.

2. Energy harvester (10) according to claim 1,
**characterized in that** the the least one thermoelectric generator (20) is produced on the substrate (22) or is fixed to the substrate (22).

3. Energy harvester (10) according to any of the preceding claims, **characterized in that** the substrate (22) is made from a semiconductor material.

4. Energy harvester (10) according to any of the preceding claims, **characterized in that** the substrate (22) forms a first wall of the chamber (16), and a cover element (24) forms a second wall of the chamber (16).

5. Energy harvester (10) according to claim 4,
**characterized in that** the first wall has protrusions (34) and recesses (36) for enlarging the contact area contacting the phase change material (44).

6. Energy harvester (10) according to any of the claims 4 or 5,
in that the cover element (24) includes an encapsulation made from a material that is transmissive for visible and/or infrared light.

7. Energy harvester (10) according to any of the claims 4 to 6,
**characterized in that** the first wall has a light absorbing surface, especially a black surface.

8. Energy harvester (10) according to any of the preceding claims,
**characterized in that** said at least one thermoelectric generator (20) is provided by a plurality of micromachined thermoelectric generators (20) formed on or being in contact with the substrate (22).

9. Energy harvester (10) according to any of the preceding claims,
**characterized in that** the at least one thermoelectric generator (20) is arranged on a side of the substrate (22) facing away from the chamber (16).

10. Energy harvester (10) according to any of the preceding claims,
**characterized in that** the substrate (22) comprises a wafer (26) wherein at least one cavity (28) filled with the heat storage medium (18) is formed in a first side of the wafer (30) and an arrangement (40) of thermoelectric generators (20) is located on a second side of the wafer (38).

11. Method for manufacturing an energy harvester (10) having at least one thermoelectric generator (20), comprising:
a) micromachining at least a part of at least one chamber (16) in a substrate (22) including micromachining a cavity (28) into the substrate (22),
b) providing a heat storage medium (18) to fill the chamber (16) including supplying a phase change material (44) as filling for the chamber (16),
c) arranging at least one thermoelectric generator (20) on or in contact with the substrate (22); and
d) closing the cavity (28) to form the chamber (16) and to enclose the phase change material (44).

12. Method according to claim 11,
**characterized in that** step a) comprises at least one, several or all of the following steps:
a1) providing a substrate (22) made from a semiconductor material;
a2) providing a wafer (26) as substrate (22);
a3) etching at least one cavity (28) into the substrate (22) to form a first side of the chamber (32),
a4) forming a side wall of the chamber (16) on the substrate (22) with protrusions (34) and recesses (36) for enlarging a contact area to be in contact with the phase change material (44); and/or
a5) treating a surface of a side wall of the chamber (16) to enlarge a heat radiation absorption capability.

13. Method according to claim 12,
**characterized in that** step a2) comprises
a2.1)forming at least one cavity (28), and preferably exactly one cavity (28), for receiving phase change material (44) in a first side of the wafer (26), and **in that** step c) comprises providing an arrangement (40) of thermoelectric generator elements (20) on a second side of the wafer (38).

14. Method according to any of the claims 11 to 13,
**characterized in that** step d) comprises at least one, several or all of the steps:
d1) attaching a cover element (24) or an encapsulation on the substrate (22) and/or
d2) providing a cover element (24) or an encapsulation made from material transparent for visible and/or infrared light.

15. Method according to any of the claims 11 to 14, **characterized in that** step c) comprises at least one, several or all of the steps:
c1) providing an arrangement (40) of a plurality of micromachined thermoelectric generators (20); and/or
c2) arranging the at least one thermoelectric generator (20) on a side of the substrate (22) facing away from the chamber (16).

## Patentansprüche

1. Energiesammler (10), umfassend zumindest einen thermoelektrischen Generator (20) und ein mikrobearbeitetes Gehäuse (14), das zumindest teilweise durch MEMS-Fertigung aus einem Substrat (22) gebildet ist, wobei in einer Kammer (16) in dem Gehäuse (14) ein Wärmespeichermedium (18) enthalten ist,
**dadurch gekennzeichnet, dass** das Wärmespeichermedium (18) ein Phasenwechselmaterial (44) ist, dass das Substrat (22) einen mikrobearbeiteten Hohlraum (28) aufweist, wobei der durch Verkapselung verschlossene Hohlraum (28) die Kammer (16) bildet, und dass die Kammer (16) das Wärmespeichermedium einschließt.

2. Energiesammler (10) gemäß Anspruch 1,
**dadurch gekennzeichnet, dass** der zumindest eine thermoelektrische Generator (20) auf dem Substrat (22) hergestellt oder an dem Substrat (22) befestigt ist.

3. Energiesammler (10) gemäß einem der vorhergehenden Ansprüche, **dadurch gekennzeichnet, dass** das Substrat (22) aus einem Halbleitermaterial besteht.

4. Energiesammler (10) gemäß einem der vorhergehenden Ansprüche, **dadurch gekennzeichnet, dass** das Substrat (22) eine erste Wand der Kammer (16) bildet und ein Abdeckelement (24) eine zweite Wand der Kammer (16) bildet.

5. Energiesammler (10) gemäß Anspruch 4,
**dadurch gekennzeichnet, dass** die erste Wand Vorsprünge (34) und Vertiefungen (36) zum Vergrößern der Kontaktfläche hat, die das Phasenwechselmaterial (44) kontaktiert.

6. Energiesammler (10) gemäß einem der Ansprüche 4 oder 5,
**dadurch gekennzeichnet, dass** das Abdeckelement (24) eine Verkapselung aufweist, die aus einem Material besteht, welches für sichtbares und/oder Infrarotlicht durchlässig ist.

7. Energiesammler (10) gemäß einem der Ansprüche 4 bis 6,
**dadurch gekennzeichnet, dass** die erste Wand eine lichtabsorbierende Oberfläche, insbesondere eine schwarze Oberfläche hat.

8. Energiesammler (10) gemäß einem der vorhergehenden Ansprüche, **dadurch gekennzeichnet, dass** der zumindest eine thermoelektrische Generator (20) durch eine Vielzahl von mikrobearbeiteten thermoelektrischen Generatoren (20) bereitgestellt wird, die auf dem Substrat (22) gebildet sind oder sich mit dem Substrat in Kontakt befinden.

9. Energiesammler (10) gemäß einem der vorhergehenden Ansprüche, **dadurch gekennzeichnet, dass** der zumindest eine thermoelektrische Generator (20) auf einer der Kammer (16) abgewandten Seite des Substrats (22) angeordnet ist.

10. Energiesammler (10) gemäß einem der vorhergehenden Ansprüche, **dadurch gekennzeichnet, dass** das Substrat (22) einen Wafer (26) umfasst, wobei zumindest ein Hohlraum (28), der mit dem Wärmespeichermedium (18) gefüllt ist, in einer ersten Seite des Wafer (30) gebildet ist und eine Anordnung (40) von thermoelektrischen Generatoren (20) sich auf einer zweiten Seite des Wafer (38) befindet.

11. Verfahren zum Herstellen eines Energiesammlers (10), der mindestens einen thermoelektrischen Generator (20) aufweist, umfassend:
a) das Mikrobearbeiten zumindest eines Teils einer Kammer (16) in einem Substrat (22), enthaltend das Mikroeinarbeiten eines Hohlraums (28) in das Substrat (22),
b) das Bereitstellen eines Wärmespeichermediums (18) zum Füllen der Kammer (16), enthaltend das Zuführen eines Phasenwechselmaterials (44) als Füllung für die Kammer (16),
c) das Anordnen zumindest eines thermoelelctrischen Generators (20) auf dem oder in Kontakt mit dem Substrat (22); und
d) das Verschließen des Hohlraums (28) zum Bilden der Kammer (16) und für den Einschluss des Phasenwechselmaterials (44).

12. Verfahren gemäß Anspruch 11,
**dadurch gekennzeichnet, dass** Schritt a) zumindest einen, mehrere oder sämtliche der folgenden Schritte umfasst:
a1) das Bereitstellen eines Substrats (22), das aus einem Halbleitermaterial besteht;
a2) das Bereitstellen eines Wafer (26) als Substrat (22);
a3) das Ätzen zumindest eines Hohlraums (28) in das Substrat (22), um eine erste Seite der Kammer (32) zu bilden,
a4) das Bilden einer Seitenwand der Kammer (16) auf dem Substrat (22) mit Vorsprüngen (34) und Vertiefungen (36) zum Vergrößern einer Kontaktfläche für den Kontakt mit dem Phasenwechselmaterial (44); und/oder
a5) das Behandeln einer Oberfläche einer Seitenwand der Kammer (16) zum Vergrößern des Wärmestrahlungs-Absorptionsvermögens.

13. Verfahren gemäß Anspruch 12, **dadurch gekennzeichnet, dass** Schritt a2) umfasst:
a2.1) das Bilden zumindest eines Hohlraums (28) und vorzugsweise genau eines Hohlraums (28) für die Aufnahme von Phasenwechselmaterial (44) in einer ersten Seite des Wafer (26) und dass Schritt c) das Vorsehen einer Anordnung (40) von thermoelektrischen Generatorelementen (20) auf einer zweiten Seite des Wafer (38) umfasst.

14. Verfahren gemäß einem der Ansprüche 11 bis 13,
**dadurch gekennzeichnet, dass** Schritt d) zumindest einen, mehrere oder sämtliche der folgenden Schritte umfasst:
d1) das Anbringen eines Abdeckelements (24) oder einer Verkapselung an dem Substrat (22) und/oder
d2) das Vorsehen eines Abdeckelements (24) oder einer Verkapselung aus einem für sichtbares und/oder Infrarotlicht transparentem Material.

15. Verfahren gemäß einem der Ansprüche 11 bis 14,
**dadurch gekennzeichnet, dass** Schritt c) zumindest einen, mehrere oder sämtliche der folgenden Schritte umfasst:
c1) das Vorsehen einer Anordnung (40) einer Vielzahl von mikrobearbeiteten thermoelektrischen Generatoren (20); und/oder
c2) das Anordnen des zumindest einen thermoelektrischen Generators (20) auf einer der Kammer (16) abgewandten Seite des Substrats (22).

## Revendications

1. Collecteur d'énergie (10), comprenant au moins un générateur thermoélectrique (20), et un logement micro-usiné (14) formé au moins partiellement par fabrication MEMS à partir d'un substrat (22), dans laquelle un milieu de stockage de chaleur (18) est inclus dans une chambre (16) dans le logement (14) **caractérisée en ce que** le milieu de stockage de chaleur (18) est un matériau à changement de phase (44), **en ce que** le substrat (22) a une cavité micro-usinée (28), dans laquelle la cavité (28) fermée par une encapsulation forme la chambre (16), et **en ce que** la chambre (16) renferme le milieu de stockage de chaleur.

2. Collecteur d'énergie (10) selon la revendication 1,
**caractérisée en ce qu'**au moins un générateur thermoélectrique (20) est produit sur le substrat (22) ou est fixé au substrat (22).

3. Collecteur d'énergie (10) selon l'une quelconque des revendications précédentes,
**caractérisée en ce que** le substrat (22) est créé à partir d'un matériau semi-conducteur.

4. Collecteur d'énergie (10) selon l'une quelconque des revendications précédentes,
**caractérisée en ce que** le substrat (22) forme une première paroi de la chambre (16), et un élément de couvercle (24) forme une seconde paroi de la chambre (16).

5. Collecteur d'énergie (10) selon la revendication 4,
**caractérisée en ce que** la première paroi comporte des saillies (34) et des renfoncements (36) pour agrandir la superficie de contact entrant en contact avec le matériau à changement de phase (44).

6. Collecteur d'énergie (10) selon l'une quelconque des revendications 4 ou 5,
**caractérisée en ce que** l'élément de couvercle (24) inclut une encapsulation créée à partir d'un matériau qui est transmissif pour la lumière visible et/ou infrarouge.

7. Collecteur d'énergie (10) selon l'une quelconque des revendications 4 à 6,
**caractérisée en ce que** la première paroi a une surface d'absorption de lumière, spécialement une surface noire.

8. Collecteur d'énergie (10) selon l'une quelconque des revendications précédentes,
**caractérisée en ce qu'**au moins un générateur thermoélectrique (20) est fourni par une pluralité de générateurs thermoélectriques micro-usinés (20) formés sur ou en contact avec le substrat (22).

9. Collecteur d'énergie (10) selon l'une quelconque des revendications précédentes,
**caractérisée en ce qu'**au moins un générateur thermoélectrique (20) est agencé sur un côté du substrat (22) tourné à l'opposé de la chambre (16).

10. Collecteur d'énergie (10) selon l'une quelconque des revendications précédentes,
**caractérisée en ce que** le substrat (22) comprend une plaquette (26) dans laquelle au moins une cavité (28) remplie du milieu de stockage de chaleur (18) est formée dans un premier côté de la plaquette (30) et un agencement (40) de générateurs thermoélectriques (20) se situe sur un second côté de la plaquette (38).

11. Procédé pour fabriquer un collecteur d'énergie (10) ayant au moins un générateur thermoélectrique (20), comprenant :
a) le micro-usinage d'au moins une partie d'au moins une chambre (16) dans un substrat (22) incluant le micro-usinage d'une cavité (28) dans le substrat (22),
b) la fourniture d'un milieu de stockage de chaleur (18) pour remplir la chambre (16) incluant l'apport d'un matériau à changement de phase (44) comme charge de remplissage pour la chambre (16),
c) l'agencement d'au moins un générateur thermoélectrique (20) sur ou en contact avec le substrat (22) ; et
d) la fermeture de la cavité (28) pour former la chambre (16) et pour enfermer le matériau à changement de phase (44).

12. Procédé selon la revendication 11,
**caractérisé en ce que** l'étape a) comprend au moins une, plusieurs ou la totalité des étapes suivantes :
a1) la fourniture d'un substrat (22) créé à partir d'un matériau semi-conducteur ;
a2) la fourniture d'une plaquette (26) en tant que substrat (22) ;
a3) la gravure d'au moins une cavité (28) dans le substrat (22) pour former un premier côté de la chambre (32),
a4) la formation d'une paroi latérale de la chambre (16) sur le substrat (22) avec des saillies (34) et des renfoncements (36) pour agrandir une superficie de contact pour mise en contact avec le matériau à changement de phase (44) ; et/ou
a5) le traitement d'une surface d'une paroi latérale de la chambre (16) pour agrandir une capacité d'absorption de rayonnement thermique.

13. Procédé selon la revendication 12,
**caractérisé en ce que** l'étape a2) comprend
a2.1) la formation d'au moins une cavité (28), et de préférence exactement une seule cavité (28), pour recevoir le matériau à changement de phase (44) dans un premier côté de la plaquette (26), et
**en ce que** l'étape c) comprend la fourniture d'un agencement (40) d'éléments générateurs thermoélectriques (20) sur un deuxième côté de la plaquette (38)

14. Procédé selon l'une quelconque des revendications 11 à 13, **caractérisé en ce que** l'étape d) comprend au moins une, plusieurs ou la totalité des étapes :
d1) la fixation d'un élément de couvercle (24) ou une encapsulation sur le substrat (22) et/ou
d2) la fourniture d'un élément de couvercle (24) ou d'une encapsulation créé à partir d'un matériau transparent pour la lumière visible et/ou infrarouge.

15. Procédé selon l'une quelconque des revendications 11 à 14, **caractérisé en ce que** l'étape c) comprend au moins une, plusieurs ou la totalité des étapes :
c1) la fourniture d'un agencement (40) d'une pluralité de générateurs thermoélectriques micro-usinés (20) ; et/ou
c2) l'agencement d'au moins un générateur thermoélectrique (20) sur un côté du substrat (22) tourné à l'opposé de la chambre (16).
